# EUROPEAN PATENT SPECIFICATION

(11) **EP 3 394 626 B1**
(45) Date of publication and mention of the grant of the patent: **16.10.2019**
(21) Application number: 15832925.0
(22) Date of filing: 30.12.2015
(51) Int. Cl.: G01R 33/30

(54) **A PROTECTIVE COVER FOR USE IN NUCLEAR MAGNETIC RESONANCE SPECTROMETERS**
SCHUTZABDECKUNG ZUR VERWENDUNG IN KERNMAGNETISCHEN RESONANZSPEKTROMETERN
COUVERCLE DE PROTECTION À ÊTRE UTILISÉ DANS DES SPECTROMÈTRES À RÉSONANCE MAGNÉTIQUE NUCLÉAIRE

(30) Priority: 25.12.2015 TR 201516968
(43) Date of publication of application: 31.10.2018
(73) Proprietor: Gebze Teknik Universitesi, 41400 Gebze/Kocaeli (TR)
(72) Inventor: AHSEN, Vefa, 41400 Gebze/Kocaeli (TR)
(74) Representative: Berkkam, Ayfer
(86) International application number: PCT/TR2015/050296
(87) International publication number: WO 2017/111719

(56) References cited:
- GB-A- 190 209 348
- JP-U- S6 169 148
- US-A- 4 581 583
- US-A- 5 952 831
- US-A1- 2005 258 834

## Description

### Technical Field

The present invention is related to a protective cover for probes of nuclear magnetic resonance devices. The invention is particularly related to a protective cover which prevents problems that may be caused if the opening of the air flow is forgotten when the sample tube is being inserted inside the device.

### Prior Art

A sample is placed inside a glass tube in order to perform measurements in nuclear magnetic resonance (NMR) devices. Air flow is used in order to insert said glass tube into the device. This sample tube which is made of glass, is suspended down into the device by means of a spinner (such as a parachute) which enables the tube to float on air.

When the air flow which enables the sample tube to be inserted into the device, is forgotten to be opened, the sample tube may fall into the probe (barrel) and break and as a result problems such as the device being damaged or being contaminated may be encountered. Particularly, the NMR devices and the probes used in these devices are formed of electronic parts and they are highly sensitive and very expensive. For this reason, the most important problems that may be encountered while using said devices is for the sample tube to be dropped into the probe and to be broken; especially if we take into consideration that the contents of the samples are chemical components, said chemicals may negatively affect the precision of the probes, and may render the probe completely useless.

Various applications have been developed in the technique, in order to prevent the problems mentioned above. In the Chinese utility model document of the known state of the art numbered CN103383399, a device used for placing the samples into NMR devices is described. Said device, enables to place the samples into an NMR device safely and quickly.

In the English Patent Document of the known state of the art numbered GB1330384, an application which improves the placement and removal of samples into NMR devices is described.

In the United States patent document of the known state of the art numbered US4088944 an application which uses air flow in order to position the sample tube is described.

In the United States patent document numbered US4581583, a sample excharger for an NMR apparatus is disclosed. The device disclosed in this document contains a protective cover which protects the bore of the NMR spectrometer, when arranged such that neither samples for the inner nor the outher row can be positioned in the bore of the spectrometer.

In the United States patent document numbered US2005258834, a nuclear magnetic resonance apparatus which allows to protect the sample with a sample catcher from entering the magnet bore of NMR apparatus in the event of loss of compressed gas is disclosed.

However all of these patent documents mentioned above describe systems and applications which are very expensive. Therefore the need for a much simpler and low cost solution has emerged.

Together with the prevention of the breakage of the sample tube, a requirement for a cover that enables the small amount of air flow that has been created during measuring to be discharged out of the device, and which shall protect the device against the dust present in the laboratory environment and against heat isolation, has risen.

### Brief Description of the Invention and its Aims

The aim of the invention is to provide a protective cover which does not allow the insertion of the sample tube into the device without the airflow being opened in NMR devices.

Another aim of the present invention is to provide a protective cover which shall aid in protecting the device against the dust in laboratory environment. Another aim of the invention is to provide a protective cover which shall contribute to the heat insulation of the magnet of the device.

Another aim of the invention is to provide a protective cover which enables the discharging of a small amount of low pressure air that is created during the spinning of the sample tube during measuring, following the shutting off of the air flow and the insertion of the sample tube into the probe.

This aim is achieved with a protective cover in accordance with claim 1 or claim 2, respectively.

The protective cover that has been developed in order to reach the aims of the present invention comprises:
- A lid which closes the opening of the probe barrel and which can be opened by means of the air flow that is created,
- A connection part for engaging the lid to the barrel opening and
- A hinge which enables to open and close the lid and provides communication with the connection part of the closing.

### Detailed Description of the Invention

The protective cover which is developed in order to reach the aims of the present invention has been illustrated in the attached figures.

According to the Figures;
**Figure-1** Is the top schematic view of the protective cover subject to the invention.
**Figure-2** Is the blown up schematic view of an embodiment of the protective cover subject to the invention.
**Figure-3** Is the schematic view of an embodiment of the protective cover of the invention that has been attached to the barrel opening.
**Figure-4** Is the schematic view of another embodiment of the protective cover of the invention.
**Figure-5** Is the schematic view of another embodiment of the protective cover of the invention that has been attached to the barrel opening.
**Figure-6** Is the schematic view of the protection cover of the invention that has been attached to the barrel opening, having a cover spring.

The parts in the figures have each been numbered and the references of said numbers have been listed below.
- **1.**: Protective Cover
- **2.**: Lid
- **3.**: Ring
- **4.**: Ring shaft slot
- **5.**: Closing shaft slot
- **6.**: Shaft
- **7.**: First part of the hinge
- **8.**: Adhesion section
- **9.**: Bellow
- **10.**: Barrel
- **11.**: Aperture
- **12.**: Cover spring

The protective cover (1) developed in order to reach the aims of the invention comprises,
- A lid (2) which is attached to the barrel (10) opening, and opens by means of the air flow that is created, and enables the sample tube to be inserted into the barrel (10) and closes on its own, when the air flow is shut off, to seal off the opening of the barrel (10),
- Apertures (11) located on the closing (2) that enables the air flow that is created inside the device during measuring.

The protective cover (1) subject to the invention comprises a preferably C shaped ring (3) that has an open end in order for the lid (2) to be attached to the opening of the barrel (10).

According to an embodiment of the protective cover (1) subject to the invention comprises a ring shaft slot (4) on the ring in order for the lid (2) to be attached to the ring (3), a closing shaft slot (5) located on the lid (2), and a shaft (6) which passes through the ring shaft slot (4) and the closing shaft slot (5) in order to enable the coupling of the lid (2) to the ring (3) and to open and close the lid (2).

According to another embodiment of the protective cover (1) subject to the invention, the cover comprises a hinge comprises a first part of the hinge (7) fixed to the lid (2), a bellow (9) thereon enabling the lid (2) to be opened and closed, and an adhesion section (8) in order for the hinge, and in turn for the lid (2) to be attached to the opening of the barrel (10).

The protective cover (1) subject to the invention comprises a lid (2) having a size that can close the opening of the barrel (10). The lid (2) is attached to the opening of the barrel (10). When the NMR device is not being used, the lid (2) seals off the opening of the barrel (10) of said NMR device. When the device is desired to be used, it is highly important for the air flow to be opened in order for the sample tube to be inserted. As the lid (2) is closed, the user must provide the air flow before introducing the sample tube. After air flow is provided, the lid (2) opens by means of the air flow and allows the positioning of the sample tube by the user. After the sample tube has been positioned, and the air flow is shut off, the lid (2) shall also close on its own, due to its own weight.

When the lid (2) is opened by means of air flow, and the sample tube is taken out when the air flow is shut off, the maximum opening of the lid (2) should not exceed 90° in order for the lid (2) to close back. The ideal angle may vary according to the NMR device and may be between 70°-80°. It shall be possible to limit the opening of the lid (2) to 90°, by adding a component to the ring (3).
Alternatively the closing process can also be provided by means of a cover spring (12) (Figure -6). The lid (2) has closing apertures (11) thereon. These closing apertures (11) discharge the low pressure air flow that is created during measuring. However these closing apertures (11) does not prevent the opening of the lid (2) when high air pressure is created during the positioning of the sample tube.
According to an embodiment of the invention, preferably a C shaped ring (3) having an open end is used in order for the lid (2) to be mounted to the opening of the barrel (10). This ring (3) may also be snap fitted to the opening of the barrel (10), or the ring (3) may be fixed to the opening of the barrel (10) by tightening (just like in garden hoses) the ring (3) at the open end by means of a screw and a nut. As one end of the ring (3) is open, it allows the usage of barrels (10) having different diameters. (Figure -3).

The ring (3) has ring shaft slots (4) thereon, which enable the mounting of the lid (2). This ring shaped like two shaft bearings side by side, with a hollow mid section comprises a closing slot (5) on the lid (2) such that it is inserted into the hollow centre of the shaft bearings (4) (Figure-2). The closing shaft slot (5) is fitted into the cavity and the lid (3) is fixed to the ring (3) by means of a shaft (6) which is inserted through the ring shaft slots (4) and closing shaft slot (5). Moreover this shaft (6) also allows the lid (2) to open and close (Figure-1). A retaining ring can be used at each end of the shaft (6) in order to prevent the pin from dislocating over time.
According to another embodiment of the invention, a hinge that is fixed to the lid (2) is provided. According to this embodiment, the usage of a ring (3) is not required. First part of the hinge(7) is fixed to the lid (2) and the other end comprises an adhesion section (8). An undulated bellow (9) is provided at the mid section of the hinge(Figure-4).

The lid (2) provides connection of the hinge to the barrel (10) opening by the adhesion of the adhesion section (8) to the barrel (10) opening. Moreover by means of the bellow (9) both the lid (2) is coupled to the barrel (10) opening and the lid (2) is allowed to be opened and closed (Figure-5). According to this embodiment it is also enabled for the lid (2) to be used in different sized barrels (10).
By means of the protective cover (1) subject to the invention, both forgetting to open the air flow is prevented and the device is protected from the dust in the laboratory environment. Furthermore, the air flow created when the device is being operated can be discharged from the device by means of the closing apertures (11) located on the lid (2).

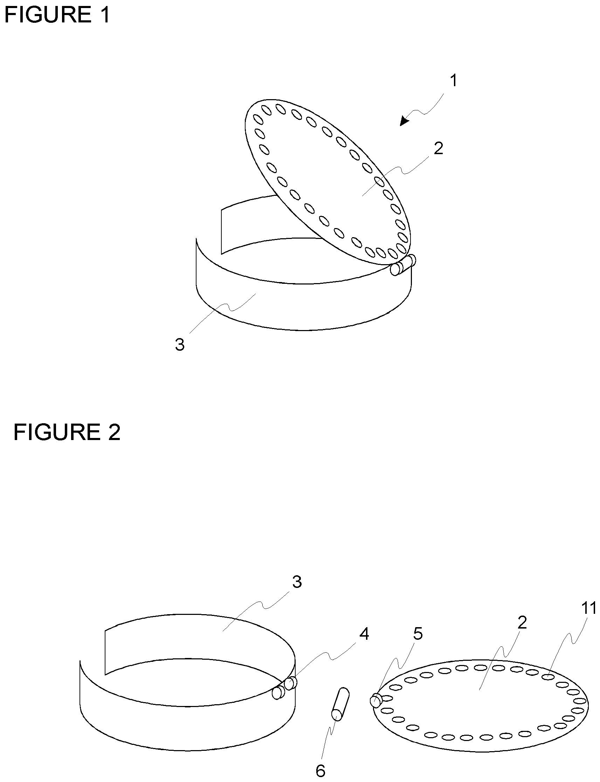

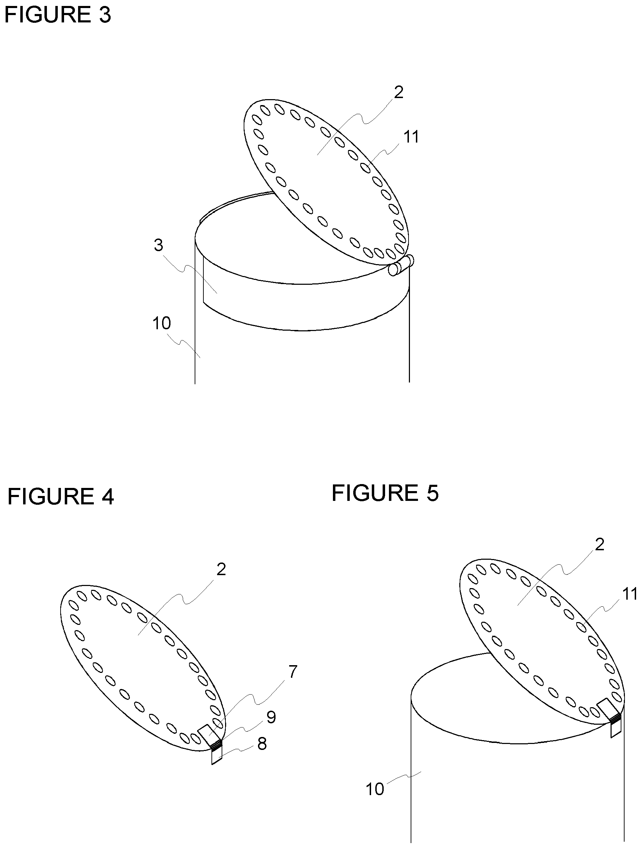

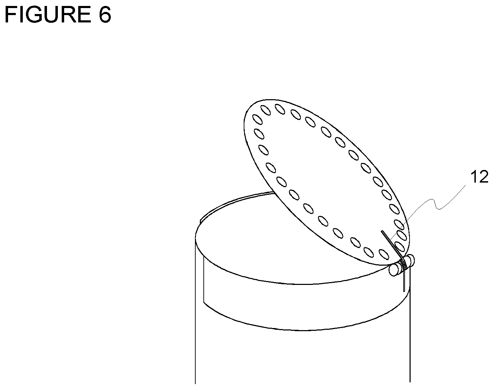

## Claims

1. A protective cover (1) for protecting the upper opening of a barrel of an NMR device, used for introducing a sample into the device, the protective cover (1) comprising;
- **a lid (2)** provided to close the opening of the barrel (10), and
- **apertures (11)** located on the lid (2)
**characterized in that** the protective cover (1) also comprises:
- **a C type ring (3)** having one open end in order to be engaged to the barrel (10) opening,
- **a ring shaft slot (4)** located on the ring (3) in order to enable the attachment of the lid (2) to the ring (3).
- **a clamp shaft slot (5)** located on the lid (2), and
- **a shaft (6)** which passes through the ring shaft slot (4) and the clamp shaft slot (5) which enable to couple the lid (2) to both the ring (3) and enable the lid to open (2) for enabling a sample tube to be inserted into the barrel (10), and close on its own in the absence of an air flow, to seal off the opening of the barrel (10).

2. A protective cover (1) for protecting the upper opening of a barrel of an NMR device, used for introducing a sample into the device, the protective cover (1) comprising;
- **a** lid (2) which is provided to close the opening of the barrel (10), and
- **apertures (11)** located on the lid (2),
**characterized in that** the protective cover (1) also comprises;
- **a hinge** which enables the lid (2) to open for enabling a sample tube to be inserted into the barrel (10), and to close on its own in the absence of an air flow, to seal off the opening of the barrel (10); the hinge further comprising a first part (7) which is fixed to the lid (2), a bellow (9) thereon and an adhesion section (8) located on the hinge, in order for the hinge and in turn the lid (2) to be mounted to the opening of the barrel (10).

## Patentansprüche

1. Schutzabdeckung (1) zum Schutz der oberen Öffnung eines Fasses einer NMR-Vorrichtung, die zum Einführen einer Probe in die Vorrichtung verwendet wird, welche Schutzabdeckung (1) umfasst;
- **einen Deckel (2),** der zum Schließen der Öffnung des Fasses (10) vorgesehen ist, und
- **Aperturen (11)** die sich am Deckel (2) befinden
**dadurch gekennzeichnet, dass** die Schutzabdeckung (1) auch Folgendes umfasst:
- **einen C-Ring (3)** mit einem offenen Ende, um mit der Öffnung des Fasses (10) in Eingriff zu kommen,
- **eine Ringwellennut (4),** die auf dem Ring (3) befindet ist, um die Befestigung des Deckels (2) an dem Ring (3) zu ermöglichen
- **einen Klemmwellennut (5),** der sich auf dem Deckel (2) befindet, und
- **eine Welle (6),** die durch den Ringwellennut (4) und den Klemmwellennut (5) verläuft, die es ermöglichen, den Deckel (2) sowohl mit dem Ring (3) als auch mit dem Deckel zu verbinden und zu öffnen (2), um das Einsetzen eines Probenrohrs in das Fass (10) zu ermöglichen, und bei Abwesenheit eines Luftstroms von selbst zu schließen, um die Öffnung des Fasses (10) abzudichten.

2. Schutzabdeckung (1) zum Schutz der oberen Öffnung eines Fasses einer NMR-Vorrichtung, die zum Einführen einer Probe in die Vorrichtung verwendet wird, welche Schutzabdeckung (1) umfasst;
- **einen Deckel (2),** der zum Verschließen der Öffnung des Fasses (10) vorgesehen ist, und
- **Aperturen (11)** die sich am Deckel (2) befinden
**dadurch gekennzeichnet, dass** die Schutzabdeckung (1) auch Folgendes umfasst:
- **ein Scharnier,** das es dem Deckel (2) ermöglicht, sich zu öffnen, damit ein Probenrohr in das Fass (10) eingesetzt werden kann, und das in Abwesenheit eines Luftstroms von selbst geschlossen werden kann, um die Öffnung des Fasses (10) abzudichten; der Scharnier ferner umfasst einen ersten Teil (7), der am Deckel (2) befestigt ist, einen Balg (9) daran und einen am Scharnier angeordneten Klebeabschnitt (8), um das Scharnier und damit wiederum den Deckel (2) an der Öffnung des Fasses (10) anzubringen.

## Revendications

1. Capot de protection (1) pour protéger l'ouverture supérieure d'un canon d'un dispositif de RMN, utilisé pour introduire un échantillon dans l'appareil, le capot de protection (1) comprenant ;
- **un couvercle (2)** prévu pour fermer l'ouverture du canon (10), et
- **ouvertures (11)** situées sur le couvercle (2)
**caractérisé en ce que** le capot de protection (1) comprend également :
- **un anneau de type C (3)** ayant une extrémité ouverte afin d'être engagée dans l'ouverture du canon (10),
- **une fente d'arbre annulaire (4)** située sur l'anneau (3) afin de permettre la fixation du couvercle (2) sur l'anneau (3).
- **une fente d'arbre de serrage (5)** située sur le couvercle (2), et
- **un arbre (6)** qui traverse la fente de l'arbre annulaire (4) et la fente de l'arbre de serrage (5) et qui permet de coupler le couvercle (2) à l'anneau (3) et permettre l'ouverture du couvercle (2) pour permettre l'insertion d'un tube échantillon dans le canon (10), et sa fermeture en l'absence de flux d'air, pour obturer l'ouverture du canon (10).

2. Capot de protection (1) pour protéger l'ouverture supérieure d'un canon d'un dispositif de RMN, utilisé pour introduire un échantillon dans l'appareil, le capot de protection (1) comprenant ;
- **un couvercle (2)** qui est prévu pour fermer l'ouverture du canon (10), et
- **ouvertures (11)** situées sur le couvercle (2),
**caractérisé en ce que** le capot de protection (1) comprend également;
- **une charnière** qui permet au couvercle (2) de s'ouvrir pour permettre l'insertion d'un tube échantillon dans le canon (10), et de se fermer seul en l'absence de flux d'air, pour obturer l'ouverture du canon (10) ; la charnière comprenant en outre une première partie (7) qui est fixée au couvercle (2), un soufflet (9) sur celui-ci et une section d'adhésion (8) située sur la charnière, pour que la charnière et le couvercle (2) soient à leur tour montés sur l'ouverture du canon (10).
